# DEMANDE DE BREVET EUROPEEN

(11) **EP 0 689 059 A1**
(43) Date de publication de la demande: **27.12.1995**
(21) Numéro de dépôt: 95410056.6
(22) Date de dépôt: 13.06.1995
(51) Int. Cl.: G01R 31/12

(54) **Dispositif de détection de décharges électriques pour appareillage électrique**

(30) Priorité: 20.06.1994 FR 9407616
(71) Demandeur: SCHNEIDER ELECTRIC SA, F-92100 Boulogne-Billancourt (FR)
(72) Inventeur: Laffont, Serge, F-38050 Grenoble Cédex 09 (FR); Maulat, Catherine, F-38050 Grenoble Cédex 09 (FR)
(74) Mandataire: Jouvray, Marie-Andrée

(57) **Abrégé**

Le dispositif de détection comporte une antenne (4) connectée à l'entrée d'un dispositif de préamplification (9). Les signaux fournis par l'antenne sont représentatifs de rayonnements électromagnétiques produits par des décharges et de la tension présente sur des conducteurs (2) de l'appareillage électrique à contrôler. Une unité de traitement (6) est reliée au dispositif d'amplification par un câble de liaison (5b). Le dispositif de préamplification comporte un circuit (11) d'amplification pour amplifier les signaux très haute fréquence et un circuit (12) d'oscillation fournissant un signal de porteuse haute fréquence modulé par les signaux représentatifs de la tension basse fréquence des conducteurs de l'appareillage. Les signaux très haute fréquence et le signal de porteuse sont envoyés dans le câble de liaison (5b) et superposés à une tension d'alimentation du dispositif de préamplification. Un circuit de test (30) compare la tension d'alimentation à une référence (REF) et applique la sortie d'un générateur de bruit à l'entrée du circuit d'amplification très haute fréquence si la valeur de référence (REF) est dépassée.

## Description

L'invention concerne un dispositif de détection de décharges électriques pour appareillage électrique comportant :
- une antenne de réception d'ondes électromagnétiques se propageant dans un appareillage électrique,
- une unité de traitement comportant une entrée pour recevoir des signaux venant de l'antenne,
- des moyens de liaison connectés entre l'antenne et l'entrée de l'unité de traitement.

Dans les appareils électriques haute tension, tels que des postes blindés isolés par un gaz diélectrique, des défauts d'isolement se manifestent par des décharges électriques. Lesdites décharges se produisent entre des conducteurs à haute tension et un blindage extérieur, en forme de cuve, au potentiel de la masse ou de la terre. Ces défauts d'isolement sont dus essentiellement à des particules libres qui se chargent électriquement et entrent en oscillation. Si ces défauts d'isolement persistent, un amorçage complet risque d'endommager le poste haute tension. Des dispositifs de surveillance détectent et localisent les défauts de manière à permettre des interventions sur le poste et éviter des amorçages complets.

Le spectre de fréquence des décharges électriques étant très large, il est connu d'utiliser des antennes pour détecter le rayonnement électromagnétique des décharges. Les antennes sont reliées à un dispositif de traitement par un câble blindé coaxial. Le dispositif de traitement analyse les signaux venant de l'antenne et signale un défaut lorsque une décharge électrique émet un rayonnement électromagnétique.

Les antennes sont généralement de faible dimension pour ne pas créer de discontinuité de champ électrique dans le poste blindé. La faible dimension de l'antenne par rapport aux longueurs d'onde reçues, implique un mauvais rendement et un rapport signal sur bruit très faible. Pour traiter les faibles signaux reçus par l'antenne, la liaison entre l'antenne et le dispositif de traitement doit être un câble coaxial à très faible perte et très onéreux.

Le dispositif de traitement a besoin, pour effectuer certaines analyses, d'informations représentatives de la tension présente sur les conducteurs haute tension. Ces informations sont souvent prélevées par des dispositifs de prise de tension installés en divers points des conducteurs. Lesdits dispositifs de prise de tension sont reliés au dispositif de traitement. Ils rendent complexe et coûteuse l'installation complète du dispositif de détection de décharge électrique.

L'invention a pour but un dispositif de détection de décharges électriques comportant une antenne fiable et économique.

Ce but est atteint par le fait que le dispositif comporte des moyens de préamplification ayant une entrée connectée à l'antenne et une sortie connectée à l'unité de traitement, l'antenne fournissant des signaux à très hautes fréquences représentatifs des ondes électromagnétiques et des signaux à basse fréquence représentatifs de la tension de conducteurs de l'appareillage électrique, les moyens de préamplification comportant :
- des moyens d'amplification des signaux très haute fréquence connectés entre l'entrée et la sortie des moyens de préamplification,
- et des moyens d'oscillation contrôlés par une tension, ayant une entrée connectée à l'entrée des moyens de préamplification et une sortie connectée à la sortie des moyens de préamplification, la sortie des moyens d'oscillation fournissant un signal de porteuse haute fréquence modulé par les signaux basse fréquence.

Dans un développement de l'invention, les moyens de préamplification comporte un générateur de signaux connecté périodiquement à l'entrée des moyens d'amplification des signaux très haute fréquence.

Selon un mode de réalisation, les moyens de préamplification comporte des moyens de contrôle comportant une entrée connectée à la sortie des moyens de préamplification et une sortie reliée à un commutateur pour appliquer le signal de sortie du générateur de signaux sur l'entrée des moyens d'amplification très haute fréquence lorsqu'une tension continue sur l'entrée des moyens de contrôle dépasse un seuil prédéterminé.

L'unité de traitement comporte un générateur de tension continue connecté à son entrée et fournissant en fonctionnement normal une première tension inférieure à la tension du seuil prédéterminé et fournissant périodiquement, en mode test, une seconde tension supérieure à la tension du seuil prédéterminé.

L'antenne est installée à l'intérieur de l'appareillage électrique et le dispositif de préamplification associé peut être installé à l'intérieur ou à l'extérieur de l'appareillage.

Dans un mode préférentiel de réalisation, l'antenne a une surface métallique formant un diviseur capacitif de tension entre un conducteur et la masse de l'appareillage électrique.

Les moyens de liaison véhiculent depuis le dispositif d'amplification vers l'unité de traitement les signaux fournis par les moyens d'amplification très haute fréquence, les signaux fournis par les moyens d'oscillation, et depuis l'unité de traitement vers les moyens d'amplification une première tension continue en mode de fonctionnement normal et une seconde tension continue différente de la première en mode de test.

D'autres avantages et caractéristiques ressortiront plus clairement de la description qui va suivre, de modes particuliers de réalisation de l'invention, donnés à titres d'exemples non limitatifs, et représentés aux dessins annexés sur lesquels :

La figure 1 représente un schéma bloc d'un dispositif de détection de décharges connu.

La figure 2 représente un schéma bloc d'un dispositif comportant un dispositif de préamplification selon un mode de réalisation de l'invention.

La figure 3 montre un schéma de détail d'un dispositif de préamplification pouvant être installé dans le dispositif de la figure 2.

La figure 4 montre un schéma partiel d'une unité de traitement.

La figure 5 représente un schéma bloc d'un dispositif selon un autre mode de réalisation de l'invention dans lequel le dispositif de préamplification et l'antenne sont à l'intérieur de la cuve.

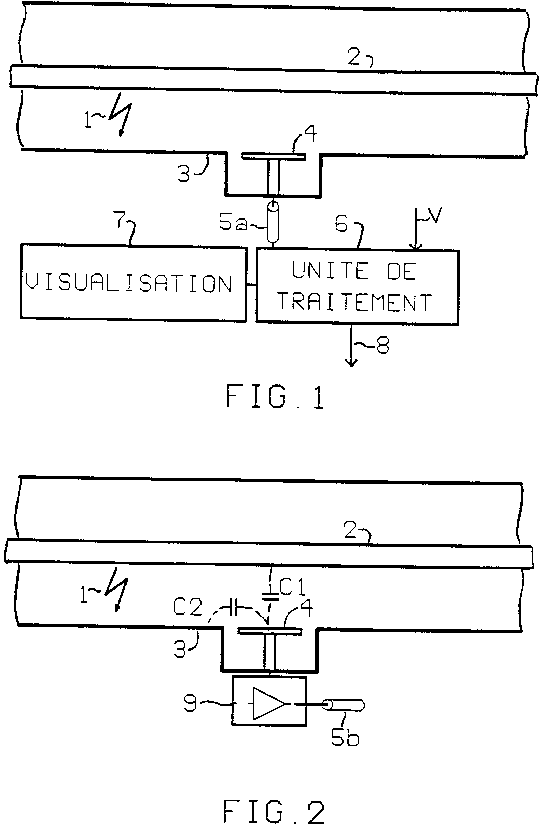

Le dispositif de détection connu de la figure 1 contrôle l'apparition de décharges électriques 1 entre un conducteur 2 à haute tension et une cuve 3 de protection à un potentiel très bas, reliée à la terre ou à la masse de l'installation. Une antenne 4 de réception capte le rayonnement électromagnétique émis par la décharge électrique 1. Un câble blindé 5a, de type coaxial, relie l'antenne à une première entrée d'une unité de traitement 6. L'unité de traitement reçoit sur une seconde entrée une information de tension V venant d'un dispositif de prise de tension. Un dispositif 7 de visualisation connecté à l'unité de traitement signale les éventuelles apparitions de décharge. L'unité de traitement peut aussi comporter une sortie de communication, connectée à un dispositif de surveillance situé à distance, pour envoyer des informations 8 concernant l'état de l'installation contrôlée par l'antenne.

Dans ce dispositif de détection, les faibles signaux recueillis par l'antenne 4 risquent d'être absorbés par le câble 5a. Ce câble 5a doit, par conséquent, être de très haute qualité.

Dans un mode de réalisation de l'invention représenté sur la figure 2, l'antenne 4 est connectée à un dispositif 9 de préamplification. L'antenne 4 détecte le rayonnement des décharges 1 et permet de mesurer la tension entre le conducteur 2 et la cuve 3. Le dispositif de préamplification 9 amplifie les signaux représentatifs des décharges électriques et des signaux représentatifs de la tension du conducteur. Ensuite, il envoie les signaux amplifiés dans un câble blindé 5b de qualité courante et d'un coût inférieur à celui utilisé dans le dispositif de détection de la figure 1.

Pour pouvoir mesurer la tension entre le conducteur 2 et la cuve 3, l'antenne est constituée de manière à former un diviseur capacitif entre le conducteur et la cuve. Le conducteur et l'antenne forment les armatures d'un premier condensateur représenté par C1 sur la figure 2 et la cuve et l'antenne sont les armatures d'un second condensateur représenté par C2. Le diélectrique des condensateurs C1 et C2 est constitué par du gaz isolant entre l'antenne et respectivement le conducteur et la cuve.

L'antenne 4 a une forme permettant d'avoir des capacités maximales avec une taille réduite. Dans un mode de réalisation préférentiel, l'antenne a une forme de disque de quelques centimètres de diamètre.

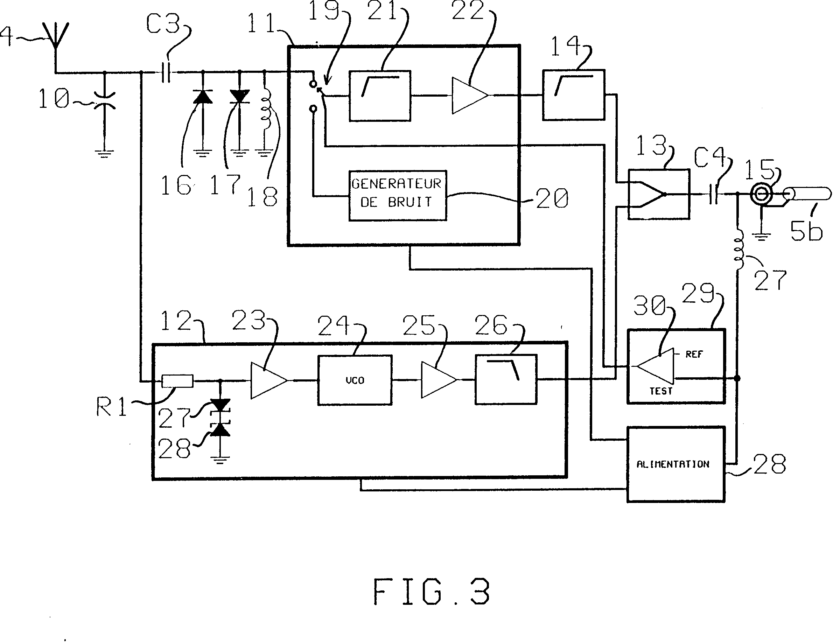

Les signaux représentatifs des décharges électriques et les signaux représentatifs de la tension du conducteur reçus par l'antenne 4 sont appliqués à l'entrée du dispositif 9 de préamplification. Dans le mode de réalisation du dispositif 9 de préamplification de la figure 3, un dispositif de protection contre les hautes tensions représenté par un éclateur 10 est connecté entre l'antenne et la masse. L'antenne est reliée à une entrée d'un circuit 11 de préamplification très haute fréquence à travers un condensateur C3, et à un circuit 12 de modulation. Une sortie du circuit 11 de préamplification très haute fréquence est connectée à une première entrée d'un coupleur 13 à travers un filtre 14 passe-haut. Une sortie du circuit 12 de modulation est connectée à une seconde entrée du coupleur 13. Une sortie du coupleur 13 est connectée à une sortie 15 du dispositif de préamplification 9 par l'intermédiaire d'un condensateur C4.

Les signaux venant de l'antenne 4 traversent le condensateur C3 de faible valeur, favorisant le passage des signaux très haute fréquence. A l'entrée du circuit 11 les signaux sont écrêtés par deux diodes 16 et 17 connectées en parallèle et en inverse entre l'entrée du circuit 11 et la masse. Une inductance 18 connectée entre l'entrée du circuit 11 et la masse élimine les composantes continues et basse fréquence du signal d'entrée.

Le circuit de préamplification 11 comporte un commutateur 19 ayant deux entrées et une sortie commune. Une première entrée connectée à C3 reçoit le signal d'entrée haute fréquence à amplifier et une seconde entrée est connectée à un générateur 20 de bruit. La sortie du commutateur 19 est connectée à l'entrée d'un filtre passe-haut 21 qui coupe les signaux basse fréquence. La sortie du filtre 21 est connectée à l'entrée d'un amplificateur très haute fréquence 22. La sortie de l'amplificateur 22, correspondant à la sortie du circuit 11, est connectée à l'entrée du filtre passe-haut 14. Le filtre 14 laisse passer les signaux haute fréquence amplifiés, atténue les signaux basse fréquence résiduels et arrête les signaux basse fréquence pouvant revenir par le coupleur 13.

Le circuit 12 de modulation comporte une résistance R1 de protection connectée entre l'entrée du circuit 12 et l'entrée d'un amplificateur 23. Deux diodes écrêteuses 27 et 28 reliées en série sont connectées entre l'entrée de l'amplificateur 23 et la masse. Les cathodes des deux diodes sont reliées ensemble et les anodes des diodes 27 et 28 sont connectées respectivement à l'entrée de l'amplificateur 23 et à la masse. La sortie de l'amplificateur 23 est connectée à un oscillateur contrôlé par une tension (VCO) 24. La sortie de l'oscillateur 24 est connectée à l'entrée d'un amplificateur 25 qui amplifie les signaux fournis par l'oscillateur 24. Un filtre passe-bas 26 est connecté entre la sortie de l'amplificateur 25 et la seconde entrée du coupleur 13, la sortie du filtre 26 correspondant à la sortie du circuit 12 de modulation.

La sortie 15, sur laquelle est connecté le câble 5b de liaison, fournit des signaux représentatifs des signaux d'antenne amplifiés et reçoit, de l'unité de traitement 6, une tension d'alimentation du dispositif 9 de préamplification. Une inductance 27 connectée entre la sortie 15 et l'entrée d'un circuit d'alimentation 28 arrête les signaux haute fréquence et laisse passer la composante continue de la tension d'alimentation. Les signaux 11 et 12 sont connectés au circuit 28 pour recevoir une tension d'alimentation filtrée et régulée. Un circuit de test 29 a une entrée connectée à l'entrée du circuit d'alimentation et une sortie pour commander le commutateur 19. Le circuit 29 comporte un comparateur 30 qui compare la tension d'alimentation d'entrée à une tension de référence REF. Si, par exemple, la tension d'entrée est supérieure à la tension de référence REF, la sortie du comparateur, correspondant à la sortie du circuit de test, positionne le commutateur 19 en test. La seconde entrée du commutateur 19 est alors reliée à sa sortie commune. Lorsque la tension d'alimentation redevient inférieure à la tension de référence REF le circuit de test repositionne le commutateur 19 dans sa position normale. La première entrée du commutateur 19 est alors reliée à sa sortie commune.

En fonctionnement normal le circuit 11 reçoit des signaux d'antenne filtrés par le condensateur C3 et l'inductance 18. Le commutateur 19 est dans sa position normale et les signaux sont filtrés par le filtre passe-haut 21, amplifiés par l'amplificateur très haute fréquence 22 et filtrés par le filtre passe-haut 14. Les deux filtres passe-haut laissent passer uniquement les très hautes fréquences, par exemple supérieures à 100 MHz. Le coupleur 13 mélange les signaux venant du circuit 11 avec les signaux de sortie du circuit 12 avant de les appliquer sur la sortie 15 à travers le condensateur C4. Sur la sortie 15 les signaux venant de C4 sont superposés à la tension continue d'alimentation. Le condensateur C4 arrête la composante continue de la tension d'alimentation et l'inductance 27 arrête les signaux très haute fréquence et haute fréquence sortant respectivement des circuits 11 et 12.

Dans le circuit 12 les signaux d'antenne sont amplifiés par un amplificateur basse fréquence 23 dont la bande passante est proche des fréquences du secteur par exemple 50 ou 60 Hz. Les signaux basse fréquence issus de l'amplificateur 23 modulent l'oscillateur 24 en amplitude ou en fréquence. La fréquence de base de l'oscillateur est, par exemple, de l'ordre de 10 MHz. Les signaux de sortie de l'oscillateur 24 sont amplifiés par l'amplificateur 25 haute fréquence dont la bande passante couvre la bande de fréquence de l'oscillateur. Le filtre passe-bas 26 arrête les signaux très haute fréquence supérieurs, par exemple, à 100 MHz. Les signaux haute fréquence de sortie du circuit 12 sont mélangés dans le coupleur aux signaux très haute fréquence de sortie du circuit 11.

En fonctionnement de test la tension d'alimentation fournie par l'unité de traitement 6 est modifiée. Le circuit de test 29 détecte le changement de tension, par exemple une augmentation, et positionne le commutateur 19 en mode test sur sa seconde position. Les signaux d'antenne ne sont plus utilisés par le circuit 11. Le générateur de bruit 20, fournissant des signaux à très large bande, est relié au filtre passe-haut 21 à travers le commutateur 19. L'amplificateur 22 et les filtres 21 et 24 amplifient et laissent passer les très hautes fréquences produites par le générateur de bruit, puis le coupleur 13 les mélange aux signaux du circuit 12 et les applique à la sortie 15. Le test permet de vérifier périodiquement le fonctionnement de la chaîne formée par les composants 21, 22, 24, 13 et 14 en simulant l'apparition d'une décharge électrique.

La tension d'alimentation peut, par exemple, avoir une valeur normale de fonctionnement de l'ordre de 12 V et être portée à 18 V pour le test du circuit 9. Mais, il est également possible, dans d'autres modes de réalisation, de baisser la tension d'alimentation pendant le test. Le circuit de test commanderait alors le commutateur dans sa seconde position si la tension est inférieure à la référence REF.

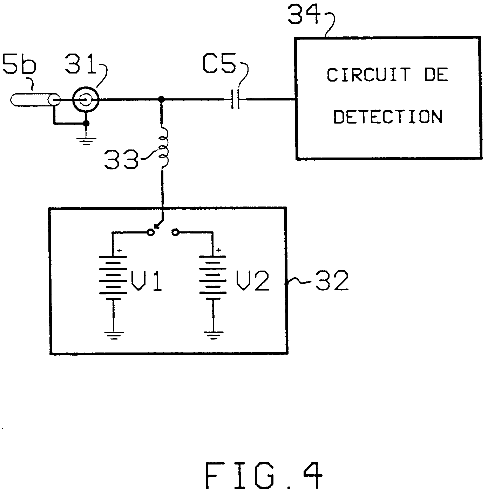

Un schéma partiel de l'unité de traitement 6 est représenté sur la figure 4. Le câble blindé 56 est relié à une entrée 31 de l'unité de traitement 6. Un générateur 32 de tension continue est connecté à l'entrée 31 à travers une inductance 33 qui arrête les courants alternatifs et laisse passer le courant continu.

Le générateur 32 fournit sur l'entrée 31 une première tension V1 en mode de fonctionnement normal et une seconde tension V2, différente de la première, en mode de test. Les tension V1 et V2 sont utilisées pour l'alimentation et la commande du test du dispositif de préamplification 9.

Un circuit 34 de détection est connecté à l'entrée 31 à travers un condensateur C5 qui laisse passer les signaux venant du coupleur 13 et bloque la composante continue de l'alimentation fournie par le générateur 32. Le circuit 34 de détection, comportant des filtres, sépare les signaux venant du circuit 11 d'amplification et les signaux fournis par l'oscillateur 12. Ensuite, lesdits signaux sont analysés, de manière connue, pour détecter la présence de décharges électriques et de défauts d'isolement.

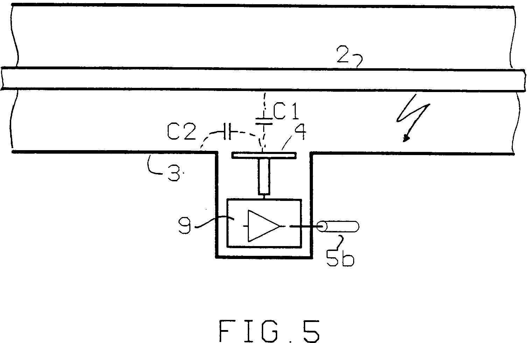

Le dispositif de préamplification 9 connecté à l'antenne 4 peut être installé à l'extérieur de la cuve 3 comme sur la figure 2 pour être facilement interchangeable. Dans un autre mode de réalisation, représenté sur la figure 5, le dispositif est installé à l'intérieur de la cuve 3 de manière à réduire la distance entre l'antenne et les circuits 11 et 12. Dans ce mode de réalisation l'ensemble constitué par l'antenne 4 et le dispositif 9 de préamplification forme une antenne active à rendement élevé ayant un bon rapport signal sur bruit.

Dans le dispositif de la figure 3, les filtres passe-haut et passe-bas sont représentés comme des composants séparés, bien qu'il soit tout à fait possible de les intégrer dans les circuits amplificateurs ou dans le coupleur 13. Les filtres passe-haut et passe-bas peuvent également être remplacés par des filtres passe-bande.

Le générateur de bruit 20 a l'avantage de couvrir une bande de fréquence très large mais tout autre générateur de signal peut être utilisé.

La fréquence de base de l'oscillateur 24 commandé en tension donnée comme exemple est de 10 MHz, mais tout autre valeur supérieure à la fréquence du réseau pourrait convenir.

## Revendications

1. Dispositif de détection de décharges électriques pour appareillage électrique comportant :
- une antenne (4) de réception d'ondes électromagnétiques se propageant dans un appareillage électrique,
- une unité de traitement (6) comportant une entrée pour recevoir des signaux venant de l'antenne,
- des moyens de liaison (5a, 5b) connectés entre l'antenne et l'entrée de l'unité de traitement,
dispositif caractérisé en ce qu'il comporte des moyens de préamplification (9) ayant une entrée connectée à l'antenne (4) et une sortie connectée à l'unité de traitement (6), l'antenne fournissant des signaux à très hautes fréquences représentatifs des ondes électromagnétiques et des signaux à basse fréquence représentatifs de la tension de conducteurs (2) de l'appareillage électrique, les moyens de préamplification comportant :
- des moyens d'amplification (11) des signaux très haute fréquence connectés entre l'entrée et la sortie des moyens de préamplification,
- et des moyens d'oscillation contrôlés par une tension (12, 24), ayant une entrée connectée à l'entrée des moyens de préamplification et une sortie connectée à la sortie des moyens de préamplification, la sortie des moyens d'oscillation fournissant un signal de porteuse haute fréquence modulé par les signaux basse fréquence.

2. Dispositif de détection selon la revendication 1 caractérisé en ce que les moyens de préamplification comporte un générateur (20) de signaux connecté périodiquement à l'entrée des moyens d'amplification des signaux très haute fréquence.

3. Dispositif de détection selon la revendication 2 caractérisé en ce que les moyens de préamplification comporte des moyens (29, 30) de contrôle comportant une entrée connectée à la sortie des moyens de préamplification et une sortie reliée à un commutateur (19) pour appliquer le signal de sortie du générateur de signaux sur l'entrée des moyens d'amplification très haute fréquence lorsqu'une tension continue sur l'entrée des moyens de contrôle dépasse un seuil prédéterminé (REF).

4. Dispositif de détection selon la revendication 3 caractérisé en ce que l'unité de traitement comporte un générateur (32) de tension continue connecté à son entrée (31) et fournissant en fonctionnement normal une première tension (V1) inférieure à la tension du seuil prédéterminé et fournissant périodiquement, en mode test, une seconde tension (V2) supérieure à la tension du seuil (REF) prédéterminé.

5. Dispositif de détection selon l'une quelconque des revendications 1 à 4 caractérisé en ce que l'antenne et son dispositif de préamplification associés sont installés tous les deux à l'intérieur de l'appareillage électrique.

6. Dispositif de détection selon l'une quelconque des revendications 1 à 4 caractérisé en ce que l'antenne est installée à l'intérieur de l'appareillage électrique et le dispositif de préamplification associé est installé à l'extérieur de l'appareillage électrique.

7. Dispositif de détection selon l'une quelconque des revendications 1 à 6 caractérisé en ce que l'antenne a une surface métallique formant un diviseur capacitif de tension entre un conducteur et la masse de l'appareillage électrique.

8. Dispositif de détection selon l'une quelconque des revendications 1 à 7 caractérisé en ce que le dispositif de préamplification (9) comporte un coupleur (13) comportant une première entrée connectée à la sortie des moyens d'amplification très haute fréquence, une seconde entrée connectée à la sortie des moyens d'oscillation contrôlés et une sortie connectée à la sortie du dispositif de préamplification.

9. Dispositif de détection selon l'une quelconque des revendications 1 à 8 caractérisé en ce que les moyens de liaison (5b) véhiculent depuis le dispositif d'amplification (9) vers l'unité de traitement (6) les signaux fournis par les moyens d'amplification très haute fréquence, les signaux fournis par les moyens d'oscillation, et depuis l'unité de traitement vers les moyens d'amplification une première tension continue (V1) en mode de fonctionnement normal et une seconde tension (V2) continue différente de la première en mode de test.
